# EUROPEAN PATENT APPLICATION

(11) **EP 1 780 798 A1**
(43) Date of publication of application: **02.05.2007**
(21) Application number: 05077458.7
(22) Date of filing: 27.10.2005
(51) Int. Cl.: H01L 27/15, H05B 33/20, H05B 33/22, H05B 33/24, G02B 3/00, G02B 5/12, G09G 3/32

(54) **Integrated led devices with increased pixel fill factor for achieving improved image quality of led display panels**

(71) Applicant: Barco, naamloze vennootschap., 8500 Kortrijk (BE)
(72) Inventor: Thielemans, Robbie, 9810 Nazareth (BE); Van Hille, Herbert, 85737 Ismaning (DE); Noyelle, Katrien, 8560 Gullegem-Wevelgem (BE)
(74) Representative: Donné, Eddy

(57) **Abstract**

Integrated light-emitting diode (LED) devices with increased pixel fill factor for achieving improved image quality of LED display panels formed therewith are disclosed. Included in multiple embodiments of the LED devices of the present invention are optical components, such as reflectors, light pipes, and/or various optical lenses, in combination with an LED. The optical components provide a broadening effect of the light beam that is emitted by the LED, which is a point source. As a result, as compared with a display that is formed by an array of standard LEDs, a display that is formed by an array of any of the LED devices of the present invention provides an increase in the perceived pixel fill factor and, thus, provides an LED display with improved image quality. Additionally, the use of the LED devices of the present invention allows a low resolution LED display to be formed at a reasonable cost, while still providing high image quality.

## Description

### AREA OF THE INVENTION

The present invention relates to light emitting display devices. In particular, this invention relates to integrated light-emitting diode (LED) devices with increased pixel fill factor for achieving improved image quality of LED display panels formed therewith.

### BACKGROUND OF THE INVENTION

There is demand in the marketplace today for large area displays (e.g., 100- to 150-inch flat panel displays) for outdoor use that have satisfactory brightness, contrast, gamma, and color. Current technologies, such as organic light-emitting diode (OLED) displays, are limiting. For example, OLED displays have limited lifetime and limited color saturation. By contrast, LEDs are particularly well suited for large area displays, such as outdoor stadium displays, because LEDs have good brightness, contrast, gamma, and color.

An LED is a point source, which is a light source that occupies a very small area and that has a concentrated output. Because an LED is a point source, each LED within an LED display has a low fill factor, which limits the overall image quality of an LED display. Fill factor is the percentage of the pixel area that is filled with emitted light.

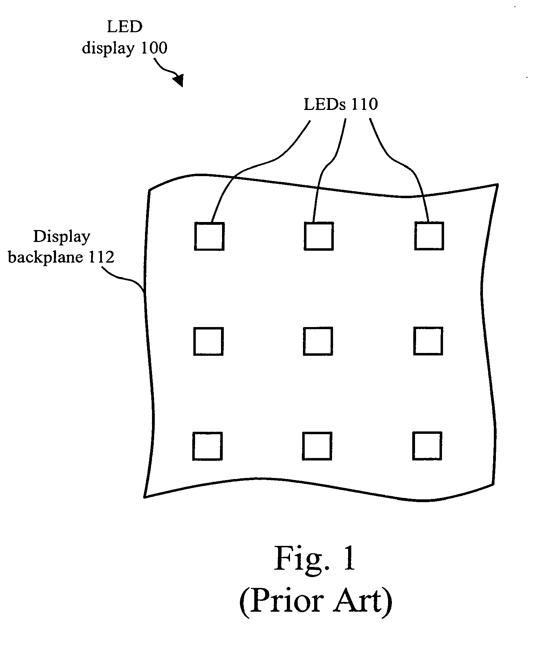

For example, Figure 1 illustrates a front view (not to scale) of a portion of an LED display 100, which is representative of a standard LED display that has a low pixel fill factor. LED display 100 includes a plurality of LEDs 110 that are arranged in an array upon a display backplane 112. LEDs 110 are, for example, standard LED chip devices, such as those supplied by Cree, Inc. (Durham, NC), Osram GmbH (Munich, Germany), or Nichia Corporation (Tokushima, Japan). LEDs 110 are well-known semiconductor devices that emit visible light when an electric current passes therethrough. Display backplane 112 is a typical display backplane for accommodating both the electrical and mechanical connections to the array of LEDs 110 mounted thereon. LEDs 110 of LED display 100 are placed on a pitch of, for example, between 3 and 25 mm, which results in a pixel fill factor of less than 5 percent. In one example, LEDs 110 are placed on display backplane 112 with a pitch of 10 mm, which yields a pixel area of 10 x 10 mm or 100 mm². If the dimensions of the light emitting surface of each LED 110 are, for example, 0.5 x 0.5 mm, the area of each LED 110 is then 0.25 mm². The resulting fill factor, which is the percentage of the pixel area that is filled with emitted light, with respect to LEDs 110, which are point sources, is then calculated as (0.25/100) x 100 = 0.25% fill factor.

Consequently, LED display 100 has a low pixel fill factor that results in the pixels of the image looking like small dots, i.e., the individual pixels are distinguishable. Thus, the image quality of LED display 100 does not suitably compare to the image quality of, for example, a liquid crystal display or an OLED display, both of which have a high pixel fill factor and, thus, the individual pixels are indistinguishable. What is needed is a way to provide an LED display with increased pixel fill factor and, thus, provide an LED display with improved image quality.

Typically, LED displays are of low resolution, because of the relatively high cost of each individual LED device. One way to compensate for the low fill factor associated with an LED display is to increase the resolution of the LED display. This is achieved by adding additional LED devices that are placed in an array on a reduced pixel pitch. Consequently, there is a conflict in the marketplace, with regard to providing an LED display of acceptable image quality, while, at the same time, maintaining low cost. More specifically, to achieve a high resolution LED display for providing high image quality, more LEDs are used, which results in an LED display that is too costly to be practical. Yet, to achieve an LED display that is of reasonable cost, the resolution and, thus, the image quality is too low to be acceptable. What is needed is a way to provide an LED display that satisfies the marketplace, with regard to both cost and image quality.

It is therefore an object of the invention to provide an LED display with increased pixel fill factor and, thus, provide an LED display with improved image quality.

It is another object of this invention to provide a low resolution LED display at a reasonable cost, while still providing high image quality.

### SUMMARY OF THE INVENTION

The present invention concerns a LED device for applying in an LED display consisting of an array of LED devices, the LED device comprising an LED and a reflector arranged as to provide a broadening effect of the light beam that is emitted by the LED.

The combination of the reflector and the LED provide a broadening effect of the light beam that is emitted by the LED, which is a point source.

As a result, as compared with a display that is formed by an array of standard LEDs, a display that is formed by an array of any of the LED devices of the present invention provides an increase in the perceived pixel fill factor and, thus, provides an LED display with improved image quality. Additionally, the use of the LED devices of the present invention allows a low resolution LED display to be formed at a reasonable cost, while still providing high image quality.

According to a preferred embodiment, the LED device is further provided with a light diverging element with an input end and an output end, whereby the reflector is directed towards the input end and whereby the LED is positioned in between the light diverging element and the reflector.

The present invention also concerns an LED display consisting of an array of LED devices according to the invention.

### BRIEF DESCRIPTION OF THE DRAWINGS

In order to better explain the characteristics of the present invention, we will describe hereafter, as an example only, some preferred embodiments of an LED device and of an LED display according to the present invention, with reference to the following drawings:
Figure 1 illustrates a front view of a portion of a standard LED display that has a low pixel fill factor;
Figures 2A and 2B illustrate a top and a side view, respectively, of an LED device in accordance with a first embodiment of the invention;
Figures 3A and 3B illustrate a top and a side view, respectively, of the LED device of the first embodiment that includes an alternative LED component;
Figures 4A and 4B illustrate a top and a side view, respectively, of the LED device of the first embodiment that includes an alternative reflector component;
Figures 5A and 5B illustrate a top and a side view, respectively, of an LED device in accordance with a second embodiment of the invention;
Figures 6A and 6B illustrate a top and a side view, respectively, of the LED device of the second embodiment that includes an alternative light pipe component;
Figures 7A and 7B illustrate a top and a side view, respectively, of the LED device of the second embodiment that includes an alternative optics component;
Figures 8A and 8B illustrate a top and a side view, respectively, of the LED device of the second embodiment that includes an alternative light pipe component;
Figures 9A and 9B illustrate a top and a side view, respectively, of the LED device of the second embodiment that includes an alternative light pipe component;
Figures 10A and 10B illustrate a top and a side view, respectively, of the LED device of the second embodiment that includes an alternative optics component and an alternative light pipe component;
Figure 11 illustrates a front view of a portion of an LED display formed of an array of LED devices of the present invention.
Figure 12 illustrates a perspective view of a multi-LED device in accordance with the invention.
Figure 13 illustrates a flow diagram of a method of making the LED devices of the present invention.

### DESCRIPTION OF THE INVENTION

The present invention is integrated LED devices with increased pixel fill factor for achieving improved image quality of LED display panels formed therewith. The LED devices of the present invention include optical components, such as reflectors, light pipes, and/or various optical lenses, in combination with an LED. The optical components provide a broadening effect of the light beam that is emitted by the LED, which is a point source.

As a result, as compared with a display that is formed by an array of standard LEDs, a display that is formed by an array of any of the LED devices of the present invention provides an increase in the perceived pixel fill factor and, thus, provides an LED display with improved image quality. Additionally, the use of the LED devices of the present invention allows a low resolution LED display to be formed at a reasonable cost, while still providing high image quality.

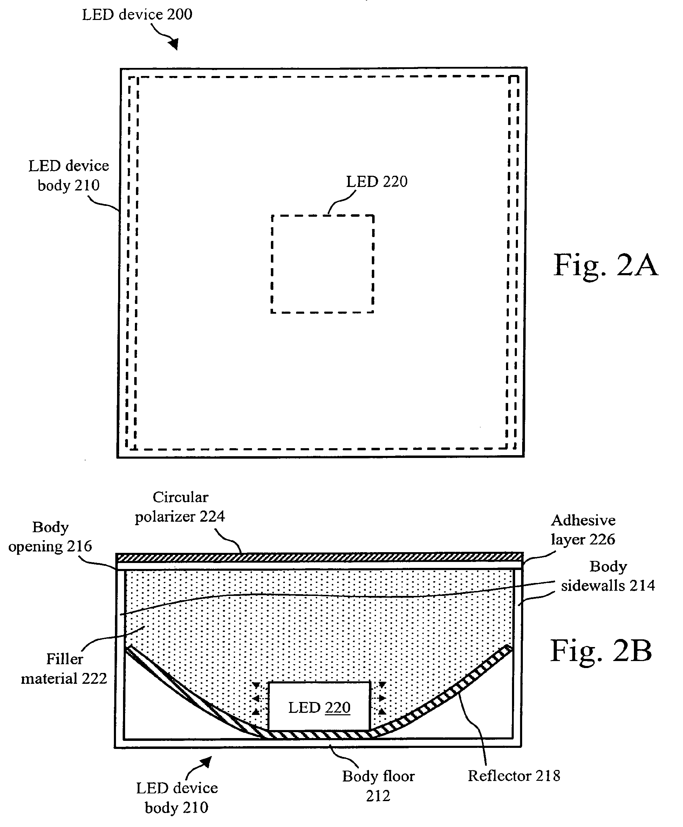

Figures 2A and 2B illustrate a top and a side view (not to scale), respectively, of an LED device 200 in accordance with the invention. LED device 200 includes an LED device body 210 that is formed of a body floor 212, a plurality of body sidewalls 214 that are orthogonally affixed at one edge about the perimeter of body floor 212, and a body opening 216 that is opposite body floor 212. LED device body 210 is formed of any suitably rigid material, such as epoxy or ceramic.

Mounted against body floor 212 within LED device body 210 is a reflector 218, which has, for example, a parabolic shape and is highly reflective. In this example, reflector 218 is a curved element that is formed of a moldable substrate, such as epoxy plastic or ceramic, which is then coated with a highly reflective layer, such as a silver layer that is a few microns thick (e.g., 2 microns thick). The substrate material of reflector 218 can be any material that is moldable, is a good carrier for a reflective coating, and is not damaged by heat that is generated by LED device 200. Reflector 218 is supported within LED device 200 by the structure of LED device body 210.

Mounted atop and at the center of reflector 218 within LED device body 210 is an LED 220, which is any commercially available LED chip device, such as is supplied by Cree, Inc. (Durham, NC), Osram GmbH (Munich, Germany), or Nichia Corporation (Tokushima, Japan). LED 220 is a well-known semiconductor device that emits visible light when an electric current passes through it. A typical LED chip device that is suitable for LED 220 has a cross sectional area of, for example, 0.25 to 0.5 mm². However, the cross sectional area of LED 220 is not limited to square. The cross sectional area of LED 220 may be, for example, rectangular, circular, or oval. In one example, the reflective layer of reflector 218, which is metal, can serve as an electrical path for bonding the anode electrode of LED 220 thereto, and the cathode electrode of LED 220 is electrically connected via a gold bond wire to an external contact (not shown). Alternatively, if reflector 218 is not in electrical contact with LED 220, there is a hole (not shown) in reflector 218 for feeding alternative electrical connections (not shown) to the electrodes of LED 220 that are electrically isolated from reflector 218.

Once reflector 218 and LED 220 are mounted within LED device body 210, a filler material 222 is applied and cured atop reflector 218 and LED 220, such that the exposed surface thereof is flush with body opening 216. Filler material 222 is an optically transparent substance, such as epoxy or silicon, which serves as a passivation layer within LED device body 210 for protecting reflector 218 and LED 220 against moisture and other contaminants. Preferably, filler material 222 ensures that LED device body 210 is free of all air pockets. Additionally, filler material 222 has suitable thermal conduction, to adequately dissipate heat that is generated within LED device 200.

A circular polarizer 224 is affixed atop filler material 222 at body opening 216 of LED device body 210 via a thin adhesive layer 226. Adhesive layer 226 is an optically transparent adhesive, such as 3M™ Optically Clear Laminating Adhesive 8141, that is applied with a thickness of, for example, 25 µm. The purpose of circular polarizer 224 is to modify ambient light as it passes therethrough and, upon reflection from the surface of reflector 218, trap the mirror image of the ambient light within LED device body 210, which is very beneficial for the contrast ratio of a display that is formed by an array of LED devices 200. Circular polarizers are available commercially in plastic or glass laminations that have a thickness ranging, for example, between 0.25 and 3.3 mm. One example supplier of circular polarizer 224 is 3M Corporation (St. Paul, MN).

The overall package dimensions of LED device 200 range, for example, but are not limited to, between 3 and 10 mm² in the cross sectional area and between 1.5 and 5 mm in height. The height dimension of LED device 200 may be, for example, half the width dimension.

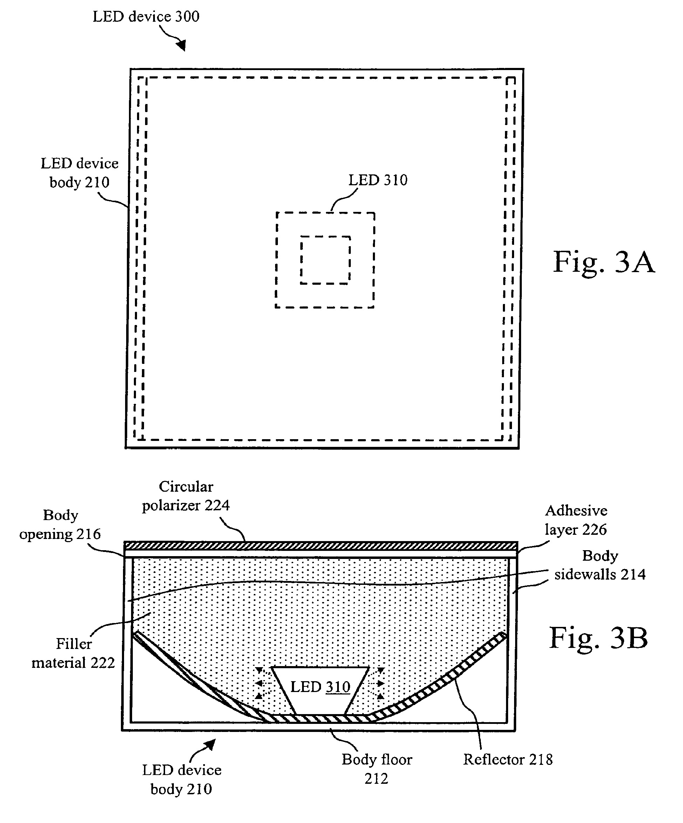

Figures 3A and 3B illustrate a top and a side view (not to scale), respectively, of an LED device 300 in accordance with the invention that includes an alternative LED component. LED device 300 and its associated elements is, in all respects, identical to LED device 200 of Figures 2A and 2B except, for the inclusion of an LED 310 that replaces LED 220. LED 310, is in all respects, identical to LED 220, except for its shape. In this example, LED 310 is tapered in a pyramid shape toward the surface of reflector 218 and, thus, the angle of the incident light that strikes reflector 218 is modified, as compared with that of LED device 200.

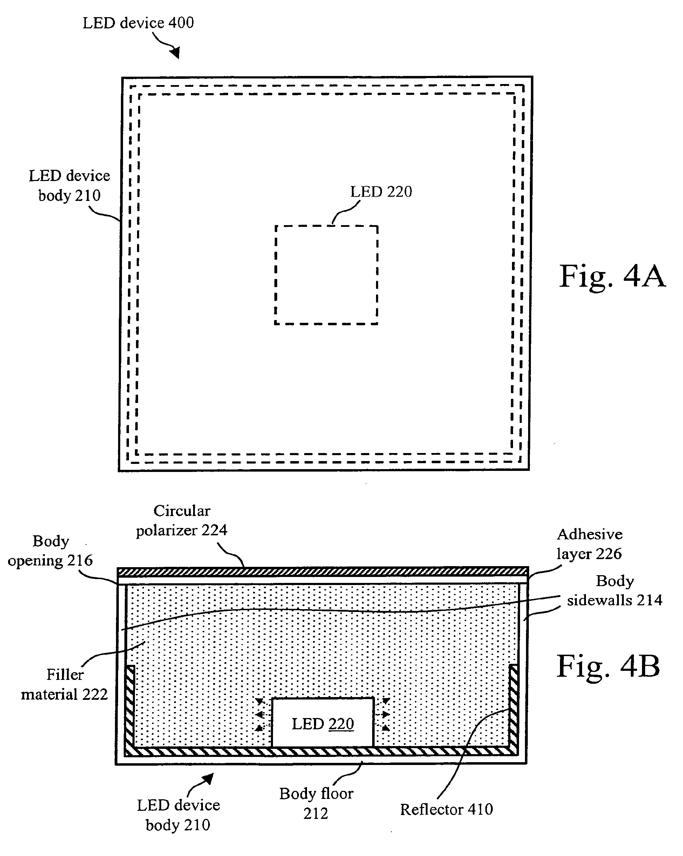

Figures 4A and 4B illustrate a top and a side view (not to scale), respectively, of an LED device 400 in accordance with the invention that includes an alternative reflector component. LED device 400 and its associated elements is, in all respects, identical to LED device 200 of Figures 2A and 2B, except for the inclusion of a reflector 410 that replaces reflector 218. Reflector 410 is, in all respects, identical to reflector 218, except for its shape. In this example, the shape of reflector 410 conforms to the shape of body floor 212 and body sidewalls 214 of LED device body 210, as shown in Figure 4B.

With continuing reference to Figures 2A, 2B, 3A, 3B, 4A, and 4B, the operation of LED devices 200, 300, and 400 is described with reference to LED device 200 as follows. A voltage is applied across the electrodes (not shown) of LED 220. Subsequently, LED 220 emits light that impinges upon the surface of reflector 218. The reflective action of reflector 218 broadens the light beam of LED 220 and, thereby, creates a wider beam that exits LED device 200 through circular polarizer 224. As a result, because of the broadening effect of reflector 218, the perceived fill factor of a display that is formed by an array of LED devices 200 is increased, as compared with that of a display that is formed by an array of LEDs 220 alone. Additionally, circular polarizer 224 blocks a large portion of the ambient light that enters LED device 200 from outside LED device 200 from reflecting back to the viewer, which is beneficial for the contrast ratio of a display formed by an array of LED devices 200.

Those skilled in the art will appreciate that the LED devices of the present invention are not limited to the LED shapes and reflector shapes shown in Figures 2A, 2B, 3A, 3B, 4A, and 4B.

With continuing reference to Figures 2A, 2B, 3A, 3B, 4A, and 4B, the properties of LED devices, such as LED device 200, 300, and 400, may be optimized, by optimizing the shape of the reflector, such as reflectors 218 and 410, to the irradiation characteristic (e.g., because of to its shape) of the LED chip, such as LEDs 220 and 310, in its mounted position. Normally, an LED emits light from all sides, but not necessarily with the same intensity. LED chips may be formed of custom geometries, such as tapered, as shown in Figure 3B, to achieve certain desired or known irradiation patterns. The reflector element may be optimized, to capture the light emitted by a certain LED chip, and reflect it out of the LED device in the most effective manner.

Furthermore, if used in a darkened environment, such as a theater environment, LED devices 200, 300, and 400 may, alternatively, exclude circular polarizer 224. In a darkened environment, the effects of ambient light are minimal and, thus, circular polarizer 224 may have the undesirable effect of reducing the overall brightness of a display formed by an array of LED devices 200, 300, or 400.

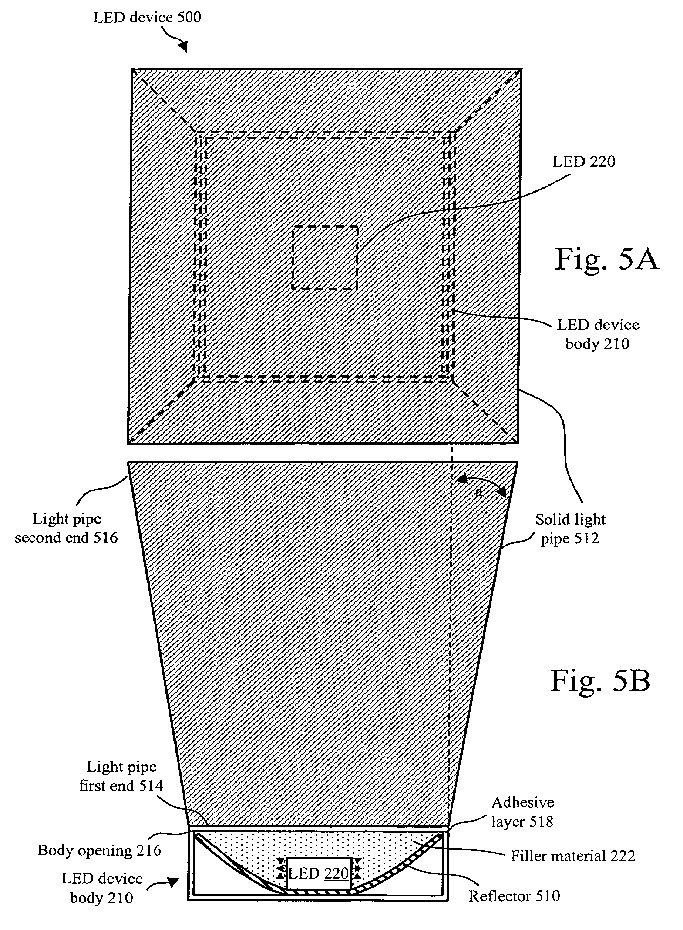

Figures 5A and 5B illustrate a top and a side view (not to scale), respectively, of an LED device 500 in accordance with the invention. LED device 500 includes LED device body 210 that is formed of body floor 212, body sidewalls 214, and has body opening 216, as described in reference to Figures 2A and 2B.

Mounted within LED device body 210 of LED device 500 is a reflector 510, which has, for example, a parabolic shape. Reflector 510 is formed with a highly reflective surface, such as is described in reference to reflector 218 of Figures 2A and 5B. However, the function of reflector 510 within LED device 500 is not as critical as the function of reflector 218 within LED device 200 and, thus, it need not be as highly reflective. Therefore, reflector 510 may be formed of a less reflective material, such as white plastic. Reflector 510 is supported within LED device 500 by the structure of LED device body 210. Mounted atop and at the center of reflector 510 within LED device 500 is LED 220, such as is described in reference to Figures 2A and 2B.

Once reflector 510 and LED 220 are mounted within LED device body 210 of LED device 500, filler material 222 is applied and cured atop reflector 510 and LED 220, such that the exposed surface thereof is flush with body opening 216, such as is described in reference to Figures 2A and 2B.

LED device 500 further includes a light diverging element such as a solid light pipe 512 that has a light pipe input end 514, which is flat and planar, and a light pipe output end 516, which is flat and planar. Light pipe input end 514 of solid light pipe 512 is affixed atop filler material 222 at body opening 216 of LED device body 210 via a thin adhesive layer 518. Adhesive layer 518 is an optically transparent adhesive, such as 3M™ Optically Clear Laminating Adhesive 8141, that is applied with a thickness of, for example, 25 µm.

The purpose of solid light pipe 512 is to serve as an optical conduit that directs the light from LED 220 that enters at light pipe input end 514 to light pipe output end 516, which is the viewing location. Solid light pipe 512 is formed of, for example, a solid piece of quartz crystal or molded plastic. Example suppliers of solid light pipes include RPM OptoElectronics (Santa Rosa, CA) and Optical Coating Laboratory, Inc., which is a wholly-owned subsidiary of JDS Uniphase (San Jose, CA).

A light pipe operates on the principal of total internal reflection (TIR). Oblique angles of light that enter at one end and hit the sides of the light pipe are reflected back into the light pipe and continue to propagate to the opposite end thereof, because of TIR. Accordingly, the light pipe directs the light that enters at one end to exit at its opposite end. The light rays are, thus, concentrated within the cross sectional area of the exit point of the light pipe. In the case of solid light pipe 512, solid light pipe 512 directs the light that enters at light pipe input end 514 to exit at light pipe output end 516. The light rays from LED 220 are, thus, concentrated within the cross sectional area of light pipe output end 516.

The sides of solid light pipe 512 may angle outward from light pipe input end 514 to light pipe output end 516, such that the cross sectional area of the light pipe at the output end is larger than the cross sectional area of the light pipe at the input end, in order to provide a larger viewing area. Figure 5B shows an angle α, which is in the range of, for example, but not limited to, between 0 and 10 degrees, with respect to an axial plane of LED device 500.

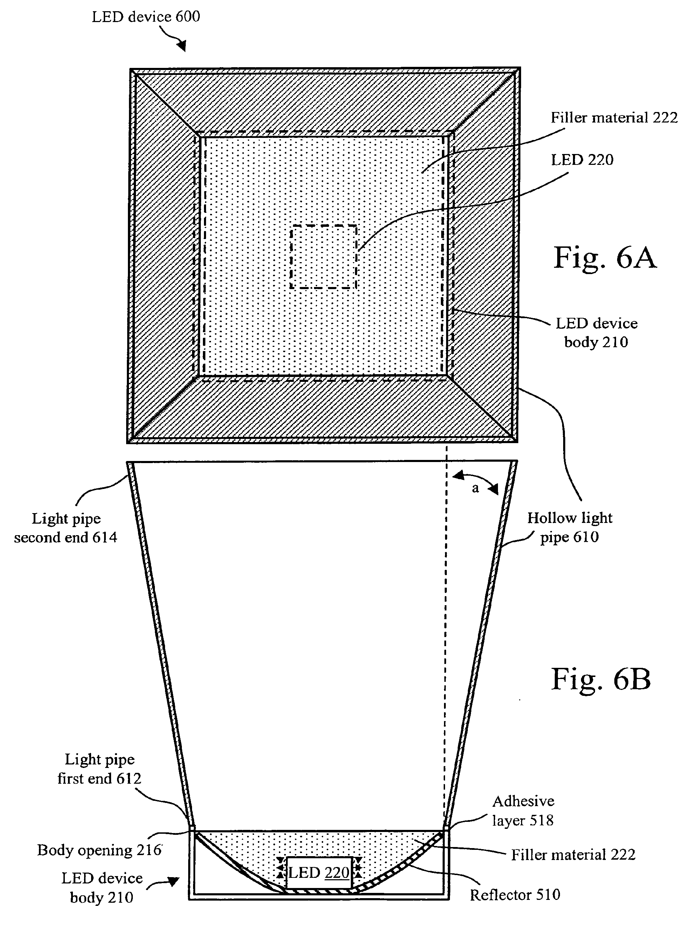

Figures 6A and 6B illustrate a top and a side view (not to scale), respectively, of an LED device 600 in accordance with the invention that includes an alternative light pipe component. LED device 600 and its associated elements is, in all respects, identical to LED device 500 of Figures 5A and 5B, except for the inclusion of a hollow light pipe 610 that replaces solid light pipe 512.

Hollow light pipe 610 has a light pipe input end 612 and a light pipe output end 614. Light pipe input end 612 of hollow light pipe 610 is affixed atop filler material 222 at body opening 216 of LED device body 210 via adhesive layer 518.

Hollow light pipe 610 is formed of a hollow structure whose inner walls are coated with a highly reflective layer, such as such as a silver layer. Like solid light pipe 512, the purpose of hollow light pipe 610 is to serve as an optical conduit that directs the light that enters at light pipe input end 612 to light pipe output end 614, which is the viewing location. More specifically, hollow light pipe 610, with its highly reflecting walls, collects light from LED 220 at light pipe input end 612 and channels it through successive reflections to light pipe output end 614. Example suppliers of hollow light pipes include RPM OptoElectronics (Santa Rosa, CA) and Optical Coating Laboratory, Inc., which is a wholly-owned subsidiary of JDS Uniphase (San Jose, CA).

Like solid light pipe 512, the sides of hollow light pipe 610 may angle outward from light pipe input end 612 to light pipe output end 614, in order to provide a larger viewing area.

Figure 6B shows the angle α, such as is described in reference to LED device 500 of Figures 5A and 5B.

With continuing reference to Figures 5A, 5B, 6A, and 6B, the operation of LED devices 500 and 600 is described with reference to LED device 500 as follows. A voltage is applied across the electrodes (not shown) of LED 220. Subsequently, LED 220 emits light that impinges upon the surface of reflector 510 and also on the surface of light pipe input end 514 of solid light pipe 512. The reflective action of reflector 510 broadens the light beam of LED 220 and, thereby, creates a wider beam that enters light pipe input end 514 of solid light pipe 512. Oblique angles of light that enter at light pipe input end 514 of solid light pipe 512 hit the sides of solid light pipe 512, are reflected back into solid light pipe 512, and continue to propagate to light pipe output end 516, because of TIR. The light rays from LED 220 are, thus, concentrated within the cross sectional area of light pipe output end 516. As a result, because of the broadening effect of reflector 510 and solid light pipe 512, the perceived fill factor of a display that is formed by an array of LED devices 500 is increased, as compared with that of a display that is formed by an array of LEDs 220 alone.

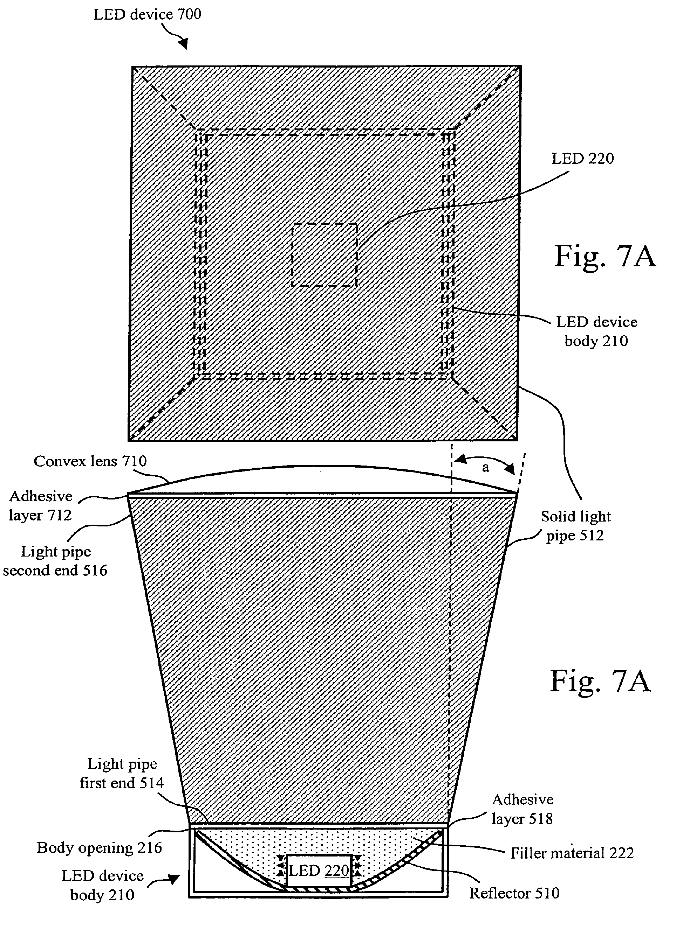

Figures 7A and 7B illustrate a top and a side view (not to scale), respectively, of an LED device 700 in accordance with the invention that includes an alternative optics component. LED device 700 and its associated elements is, in all respects, identical to LED device 500 of Figures 5A and 5B, except for the inclusion of an additional convex lens 710 that is affixed atop light pipe output end 516 of solid light pipe 512 via a thin adhesive layer 712. Adhesive layer 712 is an optically transparent adhesive, such as 3M™ Optically Clear Laminating Adhesive 8141, that is applied with a thickness of, for example, 25 µm. Convex lens 710 is a standard optical lens device, which serves to further disperse the light that exits light pipe output end 516 of solid light pipe 512 and, thus, further increases the perceived fill factor of a display that is formed by an array of LED devices 700. Additionally, the presence of convex lens 710 may serve to improve the viewing angle of LED device 700. An example supplier of convex optical lenses is Fujinon Corporation Ltd, (Saitama City, Japan).

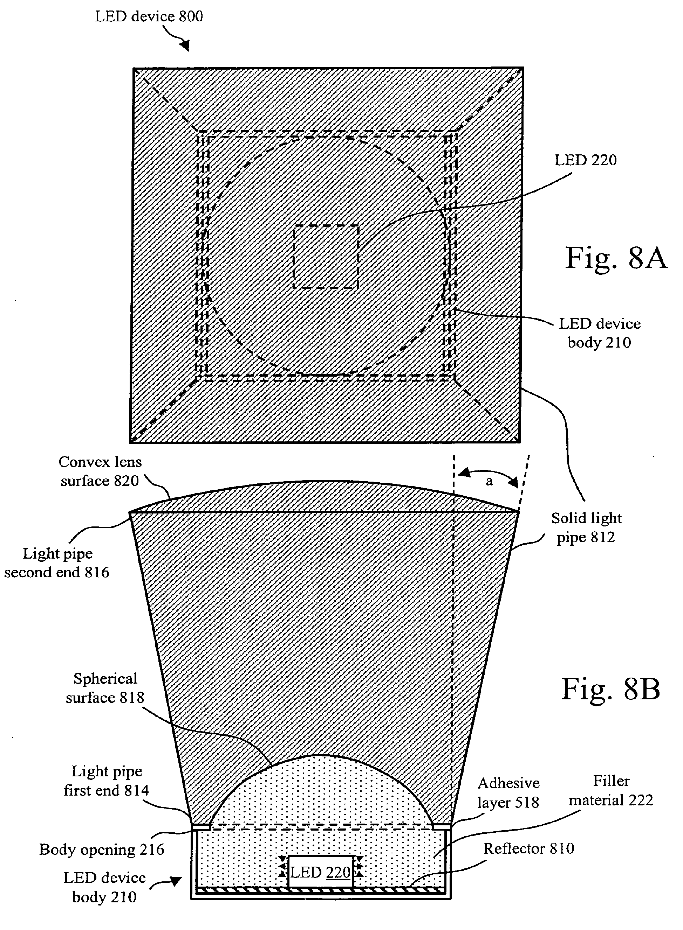

Figures 8A and 8B illustrate a top and a side view (not to scale), respectively, of an LED device 800 in accordance with the invention that includes an alternative light pipe component. LED device 800 and its associated elements is, in all respects, identical to LED device 500 of Figures 5A and 5B, except for the inclusion of a reflector 810 and a solid light pipe 812 that replaces reflector 510 and solid light pipe 512, respectively.

Mounted flat upon body floor 212 within LED device body 210 of LED device 800 is reflector 810, which has, for example, a parabolic shape. Reflector 810 is formed with a highly reflective surface, such as is described in reference to reflector 218 of Figures 2A and 2B. However, the function of reflector 810 within LED device 800 is not as critical as the function of reflector 218 within LED device 200 and, thus, it need not be as highly reflective. Therefore, reflector 810 may be formed of a less reflective material, such as white plastic. Mounted atop and at the center of reflector 810 within LED device 500 is LED 220.

Solid light pipe 812 is a standard light pipe device, such as is described in reference to solid light pipe 512 of LED device 500 of Figures 5A and 5B. Solid light pipe 812 has a light pipe input end 814 and a light pipe output end 816. Formed within light pipe input end 814 of solid light pipe 812 is a spherical surface 818 that forms a dome-like structure (i.e., a concave lens) for more efficiently capturing the light rays that are emitted by LED 220. Additionally, formed at the surface of light pipe output end 816 of solid light pipe 812 is a convex lens surface 820. Like convex lens 710 of LED device 700 of Figures 7A and 7B, convex lens surface 820 serves to further disperse the light that exits light pipe output end 816 of solid light pipe 812 and, thus, further increases the perceived fill factor of a display that is formed by an array of LED devices 800. Additionally, the presence of convex lens surface 820 may serve to improve the viewing angle of LED device 800. However, unlike convex lens 710 of LED device 700, which is a separate element, convex lens surface 820 provides an optical lens device that is directly integrated in the structure of solid light pipe 812.

Light pipe input end 814 of solid light pipe 812 is affixed atop filler material 222 at body opening 216 of LED device body 210 via adhesive layer 518. The void formed by spherical surface 818 is completely filled by filler material 222 or a potting material. This is done, for example, by use of a dispensing system that releases a drop of a precise volume of material and then solid light pipe 812 is brought together with LED device body 210. In order to ensure that no air pockets are trapped therein, any air present may be removed via a vacuum source or capillary techniques.

Like solid light pipe 512 of LED device 500 of Figures 5A and 5B, the sides of solid light pipe 812 may angle outward from light pipe input end 814 to light pipe output end 816, in order to provide a larger viewing area. Figure 8B shows the angle α, such as is described in reference to LED device 500 of Figures 5A and 5B.

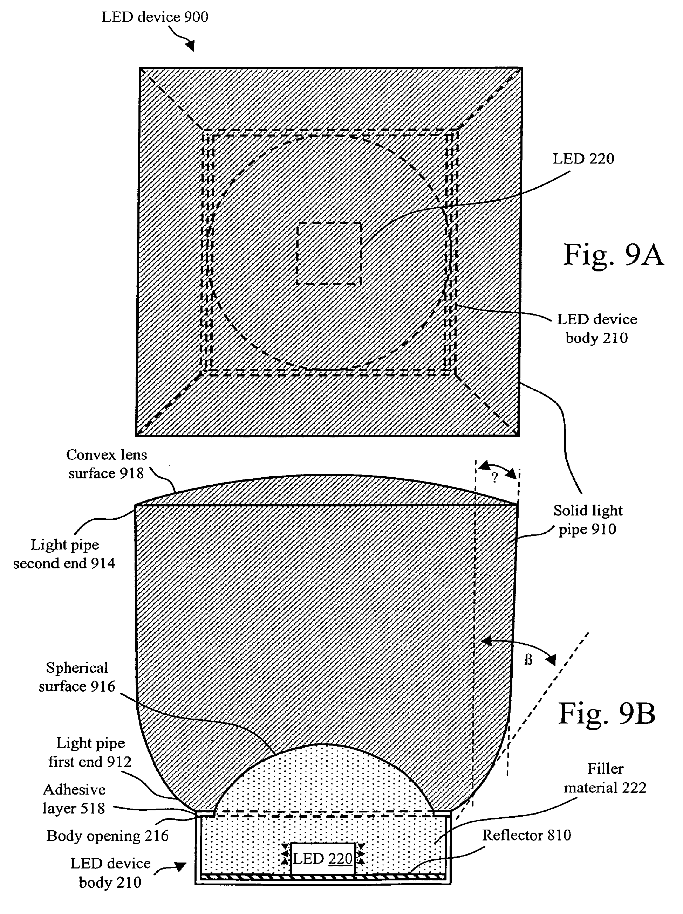

Figures 9A and 9B illustrate a top and a side view (not to scale), respectively, of an LED device 900 in accordance with the invention that includes an alternative light pipe component. LED device 900 and its associated elements is, in all respects, identical to LED device 800 of Figures 8A and 8B, except for the inclusion of a solid light pipe 910 that replaces solid light pipe 812.

Solid light pipe 910 is a standard light pipe device, such as is described in reference to solid light pipe 512 of LED device 500 of Figures 5A and 5B. Solid light pipe 910 has a light pipe input end 912 and a light pipe output end 914. Formed within light pipe input end 912 of solid light pipe 910 is a spherical surface 916, whose form and function is substantially identical to spherical surface 818 of LED device 800 of Figures 8A and 8B. Additionally, formed at the surface of light pipe output end 914 of solid light pipe 910 is a convex lens surface 918, whose form and function is substantially identical to convex lens surface 820 of LED device 800.

Light pipe input end 912 of solid light pipe 910 is affixed atop filler material 222 at body opening 216 of LED device body 210 via adhesive layer 518. The void formed by spherical surface 916 is completely filled by filler material 222 or a potting material. This is done, for example, by use of a dispensing system that releases a drop of a precise volume of material and then solid light pipe 910 is brought together with LED device body 210. In order to ensure that no air pockets are trapped therein, any air present may be removed via a vacuum source or capillary techniques.

Differing from solid light pipe 812 of LED device 800 of Figures 8A and 8B, the sides of solid light pipe 910 are outwardly curved near light pipe input end 912 at, for example, an angle β, which is in the range of, for example, but not limited to, between 0 and 30 degrees, with respect to an axial plane of LED device 800. Approaching light pipe output end 914, the sides of solid light pipe 910 are less curved at, for example, an angle γ, which is in the range of, for example, but not limited to, between 0 and 5 degrees, with respect to the axial plane of LED device 800.

The purpose of providing a light pipe whose sides are outwardly curved near LED 220 is to optimize the shape of the walls of solid light pipe 910, in order better capture the irradiation pattern of LED 220. For example, if the LED 220 irradiates from its sides, the curved walls will better capture the rays for entering solid light pipe 910, as light entering at the wrong angle will not achieve TIR. More specifically, adjusting the slope of the walls of solid light pipe 910 near LED 220 better allows the angles that qualify for TIR to be captured.

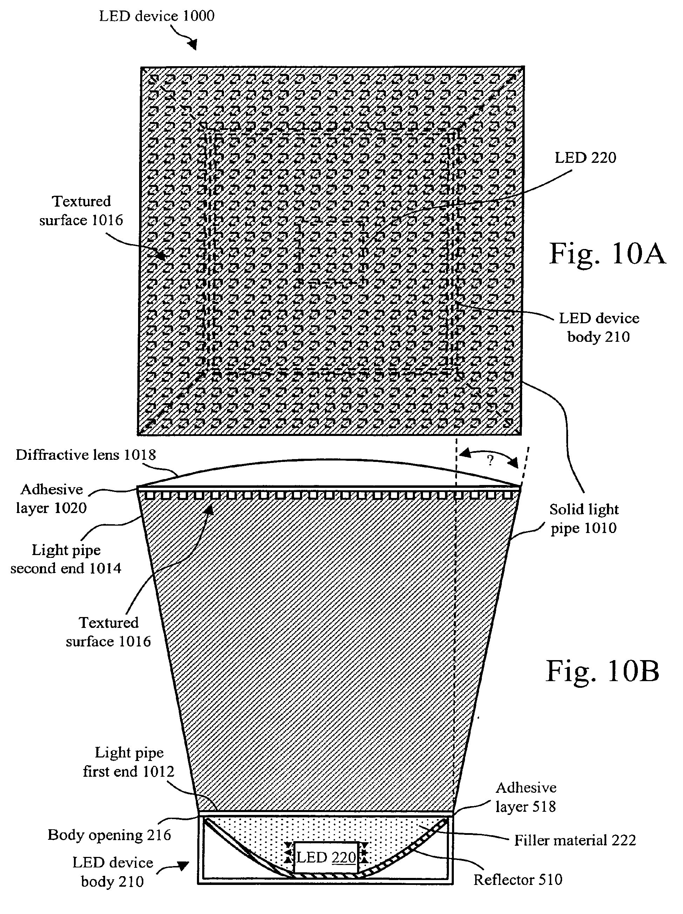

Figures 10A and 10B illustrate a top and a side view (not to scale), respectively, of an LED device 1000 in accordance with the invention that includes an alternative optics component and an alternative light pipe component. LED device 1000 and its associated elements is, in all respects, identical to LED device 500 of Figures 5A and 5B, except for the inclusion of a solid light pipe 1010 that replaces solid light pipe 512 and the addition of a diffractive lens 1018.

Solid light pipe 1010 is a standard light pipe device, such as is described in reference to solid light pipe 512 of LED device 500 of Figures 5A and 5B. Solid light pipe 1010 has a light pipe input end 1012 and a light pipe output end 1014. Solid light pipe 1010 differs from solid light pipe 512 of LED device 500 in that it includes a textured surface 1016 that is formed upon the flat surface of light pipe output end 1014. Furthermore, diffractive lens 1018 is affixed atop textured surface 1016 at light pipe output end 1014 via adhesive layer 1020. Adhesive layer 1020 is an optically transparent adhesive, such as 3M™ Optically Clear Laminating Adhesive 8141, that is applied with a thickness of, for example, 25 µm.

Diffractive lens 1018 is a standard optical device that bends and spreads light waves as they pass therethrough. An example supplier of diffraction lens is Heptagon Inc., (Espoo, Finland). The combination of textured surface 1016 together with diffractive lens 1018, serves to further disperse the light that exists light pipe output end 1014 of solid light pipe 1010 and, thus, further increases the perceived fill factor of a display that is formed by an array of LED devices 1000. An advantage of textured surface 1016 in combination with diffractive lens 1018 is that it allows the surface of light pipe output end 1014 to remain flat, while still providing some additional dispersion of the light.

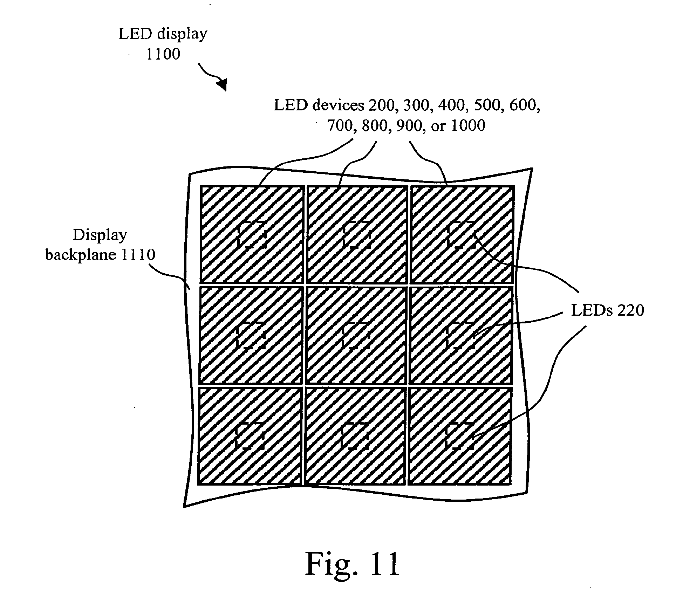

Although all include different and unique elements or features, the basic operation of LED devices 700, 800, 900, and 1000 of Figures 7A, 7B, 8A, 8B, 9A, 9B, 10A, and 10B, respectively, is substantially the same as is described in reference to reference to LED devices 500 and 600 of Figures 5A and 5B, 6A, and 6B, respectively. Accordingly, because of the broadening effect of their respective reflectors and light pipes, the perceived fill factor of a display that is formed by an array of LED devices 500, 600, 700, 800, 900, or 1000 is increased, as compared with that of a display that is formed by an array ofLEDs 220 alone. This is illustrated in more detail in reference to Figure 11.

With continuing reference to Figures 5A, 5B, 6A, 6B, 7A, 7B, 8A, 8B, 9A, 9B, 10A, and 10B, the overall package dimensions of LED devices 500, 600, 700, 800, 900, and 1000 range, for example, but are not limited to, between 3 and 10 mm² in the cross sectional area and between 1.5 and 5 mm in height. The height dimension of LED devices 500, 600, 700, 800, 900, and 1000 may be, for example, half the width dimension.

Figure 11 illustrates a front view (not to scale) of a portion of an LED display 1100 formed of an array of LED devices 200, 300, 400, 500, 600, 700, 800, 900, or 1000 of the present invention. LED devices 200, 300, 400, 500, 600, 700, 800, 900, or 1000 are mounted on a display backplane 1110, which is a typical display backplane for accommodating both the electrical and mechanical connections to the array of LEDs 220 mounted thereon.

Example fill factor calculation for using LEDs 220 alone:
With respect to the spacing of one LED 220 to the next, LEDs 220 are placed on display backplane 1110 with a pitch of, for example, 1 mm, which yields a pixel area of 1x1 mm or 1 mm². If the dimensions of each LED 220 alone (not its associated LED device assembly) are, for example, 0.25x0.25 mm, the area of each LED 220 alone is then 0.0625 mm². The resulting fill factor, which is the percentage of the pixel area that is filled with emitted light, with respect to LEDs 220 alone, which are point sources, is then calculated as (0.0625/1) x 100 = 6.25% fill factor.

Example fill factor calculation for using LED devices 200, 300, 400,500, 600, 700, 800, 900, or 1000:
The broadening effect of the various reflectors, light pipes, optical devices and/or other enhancing features within LED devices 200, 300, 400, 500, 600, 700, 800, 900, or 1000 provide an increased perceived fill factor. For example, if the dimensions of the resulting viewing area of LED devices 200, 300, 400, 500, 600, 700, 800, 900, or 1000 are, for example, 0.9x0.9 mm, their area is then 0.81 mm². For the same pixel area of 1 mm², the fill factor is then calculated as (0.81/1) x 100 = 81% fill factor.

A fill factor of 81%, as compared with 6.25%, represents an almost 13X improvement. As a result, the use of LED devices 200, 300, 400, 500, 600, 700, 800, 900, or 1000 to form an LED display, as compared to using LEDs 220 alone, provides an improved image quality, without adding additional LEDs 220 and, thus, avoids the cost thereof.

In an alternative embodiment, any LED display 1100 that is formed of LED devices 500, 600, 700, 800, 900, or 1000, which include a light pipe component, is, alternatively, formed of an assembly of multiple light pipes that is aligned and mechanically and optically coupled to an assembly of LED packages. In this case, the assembly of LED packages includes all the elements of LED devices 500, 600, 700, 800, 900, or 1000, but without the light pipe components.

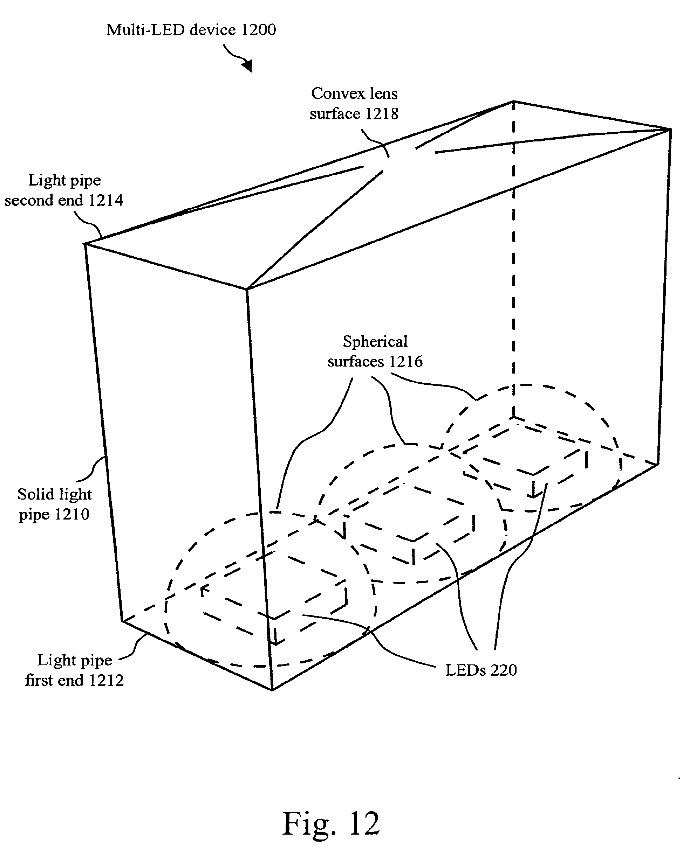

Figure 12 illustrates a perspective view (not to scale) of a multi-LED device 1200 in accordance with the invention. Multi-LED device 1200 includes a solid light pipe 1210 that has a light pipe input end 1212 and a output light pipe end 1214. Additionally, a plurality of spherical surfaces 1216 are formed at light pipe input end 1212, and a convex lens surface 1218 is formed at light pipe output end 1214. The plurality of spherical surfaces 1216 of solid light pipe 1210 is aligned with a plurality of LEDs 220, respectively. The plurality of LEDs 220 is associated with, for example, a multiple die LED package. Other elements, such as the various reflectors, light pipes, optical devices and/or other enhancing features, such as is described with reference to LED devices 500, 600, 700, 800, 900, or 1000, may be included, but, for simplicity they are not shown.

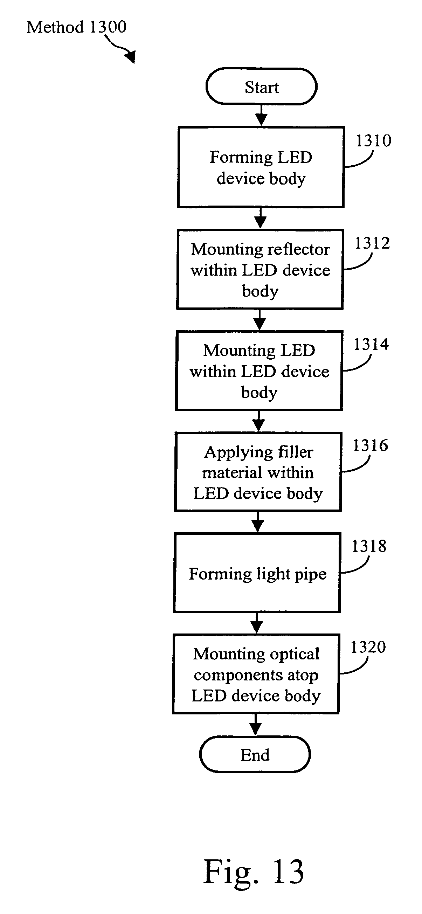

Figure 13 illustrates a flow diagram of a method 1300 of making the LED devices of the present invention. The elements of LED devices 200, 300, 400, 500, 600, 700, 800, 900, or 1000 of Figures 2A, 2B, 3A, 3B, 4A, 4B, 5A, 5B, 6A, 6B, 7A, 7B, 8A, 8B, 9A, 9B, 10A, and 10B, respectively, are referenced throughout method 1300. Method 1300 includes the steps of:

### Step 1310: Forming LED device body

In this step, an LED device body, such as LED device body 210 of LED devices 200, 300, 400, 500, 600, 700, 800, 900, or 1000 is formed of any suitably rigid material, such as epoxy or ceramic, by use of standard processes. Method 1300 proceeds to step 1312.

### Step 1312: Mounting reflector within LED device body

In this step, a reflector device, such as reflector 218, 410, 510, or 810, is mounted within the LED device body, such as LED device body 210. The reflector device is supported within LED device by the structure of its LED device body, such as by abutting body floor 212 and body sidewalls 214 of LED device body 210. Method 1300 proceeds to step 1314.

### Step 1314: Mounting LED within LED device body

In this step, an LED device, such as LED 220 or 310, is mounted atop and at the center of the reflector device, such as atop reflector 218, 410, 510 or 810, within LED device body 210. For example, the reflective layer of reflector 218, which is metal, can serve as an electrical path for bonding the anode electrode of LED 220 thereto, and the cathode electrode of LED 220 is electrically connected via a gold bond wire to an external contact (not shown). Alternatively, if reflector 218 is not in electrical contact with LED 220, there is a hole (not shown) in reflector 218 for feeding alternative electrical connections (not shown) to the electrodes of LED 220 that are electrically isolated from reflector 218. Method 1300 proceeds to step 1316.

### Step 1316: Applying filler material within LED device body

In this step, an optically transparent filler material that also serves as a passivation layer, such as filler material 222, is applied and cured atop reflector 218, 410, 510 or 810 and LED 220 or 310 within LED device body 210, by use of standard processes, such as a dispensing system. In order to ensure that no air pockets are trapped therein, any air present may be removed via a vacuum source. In the case of LED device 200, 300, 400, 500, 600, 700, or 1000, when completed, the exposed surface of filler material 222 is flush with body opening 216. However, in the case of LED devices 800 and 900 that have a void at spherical surfaces 818 and 916, respectively, filler material 222 or a potting material fills the entire void formed thereby. This is done, for example, by use of a dispensing system that releases a drop of a precise volume of material and then solid light pipe 812 or 910 are brought together with LED device body 210. Again, in order to ensure that no air pockets are trapped therein, any air present may be removed via a vacuum source or capillary techniques. Examples of optically transparent substances that serve as passivation substances are epoxy or silicon. Method 1300 proceeds to step 1318.

### Step 1318: Forming light pipe

In this step, in the case of LED devices 500, 600, 700, 800, 900, and 1000, the respective light pipes, such as solid light pipes 512, 812, 910, and 1010 and hollow light pipe 610, are formed to have a predetermined size and sidewall angles by use of standard methods, such as injection molding, casting, or micro replication. When applicable, convex lens surfaces 820 and 918 are formed by use of standard methods, such as injection molding, casting, or micro replication. When applicable, spherical surfaces 818 and 916 are formed by use of standard methods, such as injection molding, casting, or micro replication. When applicable, textured surface 1016 is formed by use of standard methods, such as injection molding, casting, or micro replication. Alternatively, solid light pipes 512, 812, 910, and 1010 are formed via methods, such as ultraviolet (UV) cure gels, to form solid light pipes 512, 812, 910, or 1010 in place atop LED device body 210, without having to use a separate passivation material and using, at most, a conformal coating to create a barrier layer for humidity. Method 1300 proceeds to step 1320.

### Step 1320: Mounting optical components atop LED device body

In this step, other optical devices, such as circular polarizer 224, convex lens 710, and diffractive lens 1018, are mounted, when applicable, by use of an optically transparent adhesive within LED device 200, 300, 400, 500, 600, 700, 800, 900, or 1000. An example, of an optically transparent adhesive is 3M™ Optically Clear Laminating Adhesive 8141. Method 1300 ends.

The LED devices of the present invention for providing an increased fill factor are not limited to the examples disclosed herein. Other variations in elements and features are possible. For example, a circular polarizer may be used in combination with a light pipe, an antireflective coating, such as magnesium fluoride (MgF2), may be applied to the output surface of the light pipe, or a diffractive lens may be mounted directly atop LED device body 210 without the use of a light pipe, and so on. Preferably, in order to ensure that no air pockets are present within LED device body 210, LED device body 210 is completely filled with filler material 222. However, alternatively, filler material 222 is a thin passivation layer atop LED 220 and its respective reflector that does not completely fill the inner cavity of LED device body 210, albeit the performance of the LED device may be reduced somewhat because of presence of air therein.

Furthermore, those skilled in the art will appreciate that the' LED devices of the present invention are not limited to the exact combinations of elements and features as disclosed herein. Any combination of elements and features for enhancing the perceived fill factor of the LED devices is possible.

In summary, LED devices 200, 300, 400, 500, 600, 700, 800, 900, or 1000 of the present invention include optical components, such as reflectors, light pipes, and/or various optical lenses, in combination with LED 220. The optical components provide a broadening effect of the light beam that is emitted by the LED 220, which is a point source. As a result, as compared with a display that is formed by an array of standard LEDs, a display that is formed by an array of any of LED devices 200, 300, 400, 500, 600, 700, 800, 900, or 1000 of the present invention provides an increase in the perceived pixel fill factor and, thus, provides an LED display with improved image quality. Additionally, the use of LED devices 200, 300, 400, 500, 600, 700, 800, 900, or 1000 of the present invention allows a low resolution LED display to be formed at a reasonable cost, while still providing high image quality.

## Claims

1. LED device for applying in an LED display consisting of an array of LED devices, **characterized in that** the LED device comprises an LED (220) and a reflector (218, 410, 510, 810) arranged as to provide a broadening effect of the light beam that is emitted by the LED (220).

2. LED device according to claim 1, **characterized in that** both the LED (220) and the reflector (218, 410, 510, 810) are covered with a cured optically transparent filler material (222), the cured filler material having an exposed surface towards which the reflector (218, 410, 510, 810) is oriented.

3. LED device according to claim 2, **characterized in that** said exposed surface (818, 916) is spherical.

4. LED device according to claim 2, **characterized in that** a circular polarizer (224) is provided on the exposed surface of the filler material (220).

5. LED device according to claim 2, **characterized in that** it comprises a light diverging element (512, 610, 812, 910, 1010) with an input end (514, 612, 814, 912, 1012) and an output end (516, 614, 816, 914, 1014), whereby the input end (514, 612, 814, 912, 1012) of the light diverging element (512, 610, 812, 910, 1010) is positioned against said exposed surface of the filler material (222), and whereby the LED (220) is positioned in between the reflector (218, 410, 510, 810) and the light diverging element (512, 610, 812, 910, 1010).

6. LED device according to claims 2 and 5, **characterized in that** the input end (514, 612, 814, 912, 1012) of the light diverging element (512, 610, 812, 910, 1010) is adhered to the exposed surface of the filler material (222).

7. LED device according to claim 5, **characterized in that** a convex lens (710) is provided at the output end (516, 614, 816, 914, 1014) of the light diverging element (512, 610, 812, 910, 1010).

8. LED device according to claim 5, **characterized in that** a diffractive lens (1018) is provided at the output end (516, 614, 816, 914, 1014) of the light diverging element (512, 610, 812, 910, 1010).

9. LED device according to claim 5, **characterized in that** the output end (516, 614, 816, 914, 1014) of the light diverging element (512, 610, 812, 910, 1010) has a textured surface (1016).

10. LED device according to claim 5, **characterized in that** the output end (516, 614, 816, 914, 1014) of the light diverging element (512, 610, 812, 910, 1010) is convex.

11. LED device according to claim 5, **characterized in that** the cross sectional area of the light diverging element (512, 610, 812, 910, 1010) increases from the input end (514, 612, 814, 912, 1012) towards the output end (516, 614, 816, 914, 1014).

12. LED device according to claim 11, **characterized in that** the sides of the light diverging element (512, 610, 812, 910, 1010) are outwardly curved near its input end (514, 612, 814, 912, 1012).

13. LED device according to claim 5, **characterized in that** the light diverging element (512, 610, 812, 910, 1010) is a light pipe.

14. LED device according to claim 1, **characterized in that** it generally comprises a device body (210) with a body floor (212) and body side walls (214), the device body (210) having a body opening (216) opposite to the body floor (212), whereby the reflector (218, 410, 510, 810) mounted within the device body (210) and oriented towards the body opening (216), whereby the LED (220) is mounted atop the reflector (218, 410, 510, 810), and whereby a filler material (222) is applied and cured atop the reflector (218, 410, 510, 810) and the LED (220) in the device body (210).

15. LED display **characterized in that** it generally consists of an array of LED devices according to any of the preceding claims.

## Amended claims

### Amended claims in accordance with Rule 86(2) EPC.

**1.** LED device for applying in an LED display consisting of an array of LED devices, **characterized in that** the LED device comprises an LED (220) and a reflector (218, 410, 510, 810) that are covered with a cured optically transparent filler material (222), the cured filler material having an exposed surface towards which the reflector (218, 410, 510, 810) is oriented, **characterised in that**
it comprises a light pipe (512, 610, 812, 910, 1010) with an input end (514, 612, 814, 912, 1012) and an output end (516, 614, 816, 914, 1014), whereby the input end (514, 612, 814, 912, 1012) of the light pipe (512, 610, 812, 910, 1010) is positioned against said exposed surface of the filler material (222), whereby the LED (220) is positioned in between the reflector (218, 410, 510, 810) and the light pipe (512, 610, 812, 910, 1010), and whereby the light pipe can operate on the principal of total internal reflecting (TIR) and has a broadening effect of the light emitted by the LED.

**2.** LED device according to claim 1, **characterized in that** the input end (514, 612, 814, 912, 1012) of the light diverging element (512, 610, 812, 910, 1010) is adhered to the exposed surface of the filler material (222).

**3.** LED device according to claim 1, **characterized in that** a convex lens (710) is provided at the output end (516, 614, 816, 914, 1014) of the light pipe (512, 610, 812, 910, 1010).

**4.** LED device according to claim 1, **characterized in that** a diffractive lens (1018) is provided at the output end (516, 614, 816, 914, 1014) of the light pipe (512, 610, 812, 910, 1010).

**5.** LED device according to claim 1, **characterized in that** the output end (516, 614, 816, 914, 1014) of the light pipe (512, 610, 812, 910, 1010) has a textured surface (1016).

**6.** LED device according to claim 1, **characterized in that** the output end (516, 614, 816, 914, 1014) of the light pipe (512, 610, 812, 910, 1010) is convex.

**7.** LED device according to claim 1, **characterized in that** the cross sectional area of the light pipe (512, 610, 812, 910, 1010) increases from the input end (514, 612, 814, 912, 1012) towards the output end (516, 614, 816, 914, 1014).

**8.** LED device according to claim 7, **characterized in that** the sides of the light pipe (512, 610, 812, 910, 1010) are outwardly curved near its input end (514, 612, 814, 912, 1012).

**9.** LED device according to claim 1, **characterized in that** it generally comprises a device body (210) with a body floor (212) and body side walls (214), the device body (210) having a body opening (216) opposite to the body floor (212), whereby the reflector (218, 410, 510, 810) mounted within the device body (210) and oriented towards the body opening (216), whereby the LED (220) is mounted atop the reflector (218, 410, 510, 810), and whereby a filler material (222) is applied and cured atop the reflector (218, 410, 510, 810) and the LED (220) in the device body (210) and whereby a light pipe is provided atop an exposed surface of the cured filter material the light pipe being arranged to operate an the principal of TIR.

**10.** LED display **characterized in that** it generally consists of an array of LED devices according to any of the preceding claims.
